# EUROPÄISCHE PATENTSCHRIFT

(11) **EP 1 055 749 B1**
(45) Veröffentlichungstag und Bekanntmachung des Hinweises auf die Patenterteilung: **03.07.2002**
(21) Anmeldenummer: 00109018.2
(22) Anmeldetag: 27.04.2000
(51) Int. Cl.: C30B 25/02, C30B 33/00, C30B 29/06, H01L 21/205

(54) **Verfahren zur Herstellung einer Halbleiterscheibe**
Process for producing a semiconductor wafer
Procédé pour la production d'une tranche de semi-conducteur

(30) Priorität: 12.05.1999 DE 19922167
(43) Veröffentlichungstag der Anmeldung: 29.11.2000
(73) Patentinhaber: Wacker Siltronic Gesellschaft für Halbleitermaterialien Aktiengesellschaft, 84489 Burghausen (DE)
(72) Erfinder: Schauer, Reinhard, 83410 Laufen (DE)
(74) Vertreter: Rimböck, Karl-Heinz, Dr.

(56) Entgegenhaltungen:
- EP-A- 0 863 540
- EP-A- 0 911 869
- WO-A-97/28560
- WO-A-99/22403
- PATENT ABSTRACTS OF JAPAN vol. 2000, no. 02, 29. Februar 2000 (2000-02-29) & JP 11 329982 A (SHIN ETSU HANDOTAI CO LTD), 30. November 1999 (1999-11-30)
- PATENT ABSTRACTS OF JAPAN vol. 1998, no. 05, 30. April 1998 (1998-04-30) & JP 10 012715 A (NEC CORP), 16. Januar 1998 (1998-01-16) & US 5 944 193 A (SHIMIZU) 31. August 1999 (1999-08-31)

## Beschreibung

Gegenstand der Erfindung ist ein Verfahren zur Herstellung einer Halbleiterscheibe, insbesondere einer Siliciumscheibe, die mit einer epitaktischen Schicht versehen ist. Die Erfindung betrifft insbesondere die Behandlung der Halbleiterscheibe nach dem Abscheiden der epitaktischen Schicht.

Es ist bekannt, daß die Oberfläche einer frisch abgeschiedenen epitaktischen Schicht dazu neigt, mit geeigneten Molekülen der Umgebung Reaktionen einzugehen. Die Hersteller elektronischer Bauelemente, die solche Halbleiterscheiben weiterverarbeiten, sind daran interessiert, daß sich die Oberfläche der Halbleiterscheibe in einem definierten Zustand befindet, das heißt, daß die weiterzuverarbeitenden Halbleiterscheiben einheitlich beschaffene Oberflächen aufweisen.

Aufgabe der Erfindung ist die Bereitstellung einer Halbleiterscheibe mit einer Oberfläche, die einen solchen definierten Zustand aufweist. Aufgabe der Erfindung ist darüber hinaus, daß die Herstellung der Halbleiterscheibe ohne besonderen Aufwand und ohne besondere Kosten in bestehende Verfahren einbezogen werden kann.

Gegenstand der Erfindung ist ein Verfahren zur Herstellung einer Halbleiterscheibe durch Abscheiden einer epitaktischen Schicht auf einer Substratscheibe in einem Abscheidereaktor, dadurch gekennzeichet, daß die Halbleiterscheibe im Anschluß an das Abscheiden der epitaktischen Schicht einer Behandlung in einem ozonhaltigen Ambient unterzogen wird.

Die Erfindung wird vorzugsweise in bestehende Abscheideverfahren integriert, bei denen neben einem oder mehrerer Abscheidereaktoren auch abschließbare Kammern zum Be- und Entladen (load lock station) vorgesehen sind. Die Behandlung kann natürlich auch in einer zusätzlich bereitgestellten Behandlungskammer erfolgen. Die Temperatur des ozonhaltigen Ambients beträgt 10°C bis 50°C, vorzugsweise Raumtemperatur. Die Dauer der Behandlung beträgt vorzugsweise 5 min bis 20 min. Durch die Behandlung bildet sich auf der Oberfläche der epitaktischen Schicht ein dünner Oxidfilm, der für alle derartig prozessierten Halbleiterscheiben eine von den Bauelementherstellern gewünschte einheitliche Beschaffenheit aufweist.

Von besonderem Vorteil ist es, wenn sichergestellt wird, daß die Halbleiterscheibe nach dem Abscheiden der epitaktischen Schicht und vor der Behandlung in dem ozonhaltigen Ambient in einem nicht-oxidierenden Ambient bleibt. Besonders bevorzugt ist es, die Halbleiterscheibe in einer Stickstoff-Atmosphäre vom Abscheidereaktor in die Behandlungskammer zu transportieren.

Das ozonhaltige Ambient wird vorzugsweise durch UV-Bestrahlung oder mit Hilfe eines handelsüblichen Ozonisators zur Verfügung gestellt, der mit Luft, besonders bevorzugt mit Sauerstoff gespeist wird. Das vom Ozonisator abgegebene ozonhaltige Gas wird in die Behandlungskammer geleitet, wobei es die bis dahin in der Kammer vorhandene Atmosphäre verdrängt. Alternativ dazu kann diese Atmosphäre auch abgesaugt werden, bevor das ozonhaltige Gas in die Behandlungskammer eintritt.

Gemäß einer besonders bevorzugten Ausführungsform des Verfahrens wird eine Horde mit mehreren Substratscheiben in eine erste Kammer (load lock station) geladen und unter eine nicht-reaktive Gasatmosphäre, vorzugsweise eine Stickstoff-Atmosphäre gebracht. Anschließend werden die Scheiben unter der eingestellten Atmosphäre in den Abscheidereaktor transportiert und darin einzeln oder in kleinen Stückzahlen mit der epitaktischen Schicht beschichtet. Danach werden die entstandenen Halbleiterscheiben unter einer nicht-reaktiven, insbesondere nicht-oxidierenden Atmosphäre in eine zweite Kammer (load lock station) transportiert und in einer weiteren Horde gesammelt. Sobald die Horde gefüllt ist, werden die Halbleiterscheiben in der zweiten Kammer der Behandlung in dem ozonhaltigen Ambient unterzogen. Während dieser Zeit kann die erste Kammer bereits wieder mit Substratscheiben beladen werden, und die ersten dieser Substratscheiben epitaktisch beschichtet werden. Selbstverständlich ist es auch möglich, die Halbleiterscheiben nach dem Beschichten in die erste Kammer zurückzutransportieren und die Behandlung in dem ozonhaltigen Ambient in dieser Kammer durchzuführen. Währenddessen können Substratscheiben aus der zweiten Kammer in den Abscheidereaktor transportiert und beschichtet werden.

Das beschriebene Verfahren ermöglicht die Herstellung epitaktischer Halbleiterscheiben mit einer einheitlichen Oberfläche. Gegenüber naßchemischen Prozessen, durch die eine ähnliche Oberfläche zur Verfügung gestellt werden kann, wie z.B. in EP-A-0863540 beschrieben wird, besitzt das Verfahren einen mindestens 80% igen Kostenvorteil.

## Patentansprüche

1. Verfahren zur Herstellung einer Halbleiterscheibe mit einer einheitlichen Oberfläche durch Abscheiden einer epitaktischen Schicht auf einer Substratscheibe aus Silicium in einem Abscheidereaktor, dadurch gekennzeichet, daß die Halbleiterscheibe im Anschluß an das Abscheiden der epitaktischen Schicht entweder in einer mit dem Abscheidereaktor verbundenen Ladestation (load lock station) oder in einer mit dem Abscheidereaktor verbundenen Behandlungskammer einer Behandlung in einem ozonhaltigen Ambient unterzogen wird, wobei sich ein dünner Oxidfilm auf der epitaktischen Schicht bildet.

2. Verfahren nach dem Anspruch 1, **dadurch gekennzeichnet, daß** die Halbleiterscheibe bei einer Ambient-Temperatur von 10°C bis 50°C dem ozonhaltigen Ambient unterzogen wird.

3. Verfahren nach einem der Ansprüche 1 bis 2, **dadurch gekennzeichnet, daß** die Halbleiterscheibe nach dem Abscheiden der eptaktischen Schicht und vor der Behandlung in dem ozonhaltigen Ambient in einem nicht-oxidierenden Ambient gehalten wird.

4. Verfahren nach einem der Ansprüche 1 bis 3, **dadurch gekennzeichnet, daß** die Halbleiterscheibe zusammen mit anderen Halbleiterscheiben der Behandlung in dem ozonhaltigen Ambient unterzogen wird.

## Claims

1. Method for producing a semiconductor wafer having a uniform surface by deposition of an epitaxial layer on a substrate wafer made of silicon in a deposition reactor, **characterized in that** the semiconductor wafer, following the deposition of the epitaxial layer, undergoes treatment in an ozone-containing atmosphere either in a load lock station which is connected to the deposition reactor or in a treatment chamber which is connected to the deposition reactor, a thin oxide film forming on the epitaxial layer.

2. Method according to Claim 1, **characterized in that** the semiconductor wafer is exposed to the ozone-containing atmosphere at an ambient temperature of 10EC to 50EC.

3. Method according to either of Claims 1 and 2, **characterized in that** the semiconductor wafer is held in a nonoxidizing atmosphere following the deposition of the epitaxial layer and prior to the treatment in the ozone-containing atmosphere.

4. Method according to one of Claims 1 to 3, **characterized in that** the semiconductor wafer undergoes the treatment in the ozone-containing atmosphere together with other semiconductor wafers.

## Revendications

1. Procédé de fabrication d'une pastille semi-conductrice ayant une surface uniforme par dépôt d'une couche épitaxiale sur une pastille substrat en silicium dans un réacteur de dépôt, **caractérisé en ce que** la pastille semi-conductrice, à la suite du dépôt de la couche épitaxiale, est soumise à un traitement dans un environnement contenant de l'ozone, soit dans un poste de chargement raccordé au réacteur de dépôt (load lock station), soit dans une chambre de traitement raccordée au réacteur de dépôt, un film mince d'oxydes se formant sur la couche épitaxiale.

2. Procédé selon la revendication 1, **caractérisé en ce que** la pastille semi-conductrice est soumise à l'environnement contenant de l'ozone à une température ambiante de 10°C à 50°C.

3. Procédé selon l'une quelconque des revendications 1 à 2, **caractérisé en ce que** la pastille semi-conductrice est maintenue, après le dépôt de la couche épitaxiale et avant le traitement dans l'environnement contenant de l'ozone, dans un environnement non oxydant.

4. Procédé selon l'une quelconque des revendications 1 à 3, **caractérisé en ce que** la pastille semi-conductrice est soumise au traitement dans l'environnement contenant de l'ozone conjointement avec d'autres pastilles semi-conductrices.
